Europäisches Patentamt

European Patent Office

Office européen des brevets

(19)

(11) Veröffentlichungsnummer: **0 119 655**
**B1**

(12) **EUROPÄISCHE PATENTSCHRIFT**

(45) Veröffentlichungstag der Patentschrift:
09.08.89

(21) Anmeldenummer: 84200357.6

(22) Anmeldetag: 13.03.84

(51) Int. Cl.⁴: **H 03 K 19/092**, H 03 K 19/091

(54) Schaltungsanordnung zur Pegelanpassung.

(30) Priorität: 16.03.83 DE 3309396

(43) Veröffentlichungstag der Anmeldung:
26.09.84 Patentblatt 84/39

(45) Bekanntmachung des Hinweises auf die Patenterteilung: 09.08.89 Patentblatt 89/32

(84) Benannte Vertragsstaaten:
DE FR GB IT NL

(56) Entgegenhaltungen:
GB—A— 2 085 248
RADIO FERNSEHE ELEKTRONIK, Band 28, Nr. 1, Januar 1979, Seiten 12-18, Berlin, DD; M. AUER: "Mikroelektronische Strukturen mit mehrwertiger Signalverarbeitung"

(73) Patentinhaber: Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
FR GB IT NL

(72) Erfinder: Reich, Joachim
Reeshoop 19a
D-2070 Ahrensburg (DE)
Erfinder: Schwarz, Henning
Cronsberg 18
D-2057 Reinbek (DE)

(74) Vertreter: Hartmann, Heinrich, Dipl.-Ing. et al
Philips Patentverwaltung GmbH Wendenstrasse 35
Postfach 10 51 49
D-2000 Hamburg 1 (DE)

## Beschreibung

Die Erfindung betrifft eine Schaltungsanordnung zur Pegelanpassung zwischen I²L-Schaltung und einer vorgeschalteten Verknüpfungsschaltung mit einer Gleichstromquelle, die mit dem Eingang eines in Abhängigkeit vom Pegel am Ausgang der Verknüpfungsschaltung steuerbaren Umschalters verbunden ist, wobei wenigstens einer der beiden Ausgänge des Umschalters mit dem Eingang eines Stromspiegels verbunden ist, dessen Ausgang mit dem Eingang der I²L-Schaltung verbunden ist.

I²L-Schaltungen (I²L = Integrierte Injektionslogik), die beispielsweise in den Valvo-Berichten, Band XVIII, Seiten 215 bis 226, sowie in Philips techn. Rdsch. 33, 1973/74, Seiten 82 bis 91, beschrieben sind, benötigen relativ niedrige Spannungspegel (0 V bzw. 0,7 V), um den einen bzw. den anderen logischen Zustand (« 0 » bzw. « 1 ») einzunehmen. Schaltungen, die nach einem anderen technologischen Prozeß hergestellt sind, wie z. B. TTL-Schaltungen liefern an ihren Ausgang jedoch wesentlich höhere Pegel, z. B. 0 V/5 V. Wenn die Ausgangssignale einer solchen Schaltung durch eine I²L-Schaltung verarbeitet werden sollen, ist daher eine Pegelanpassung erforderlich.

In den bereits genannten Valvo-Berichten (Bild 14b) ist zu diesem Zweck zwischen dem Eingang der I²L-Schaltung und den Ausgang der ihr vorausgehenden Schaltung ein Widerstand eingeschaltet. Ein Nachteil dieser Lösung besteht darin, daß dieser Widerstand verhältnismäßig groß sein muß — und zwar um so größer, je größer die Versorgungsspannung der vorangehenden Schaltung ist — weil die Eingangsströme einer I²L-Schaltung relativ klein sind (z. B. 20 uA). Ein solch hochohmiger Anpassungswiderstand würde bei Ausführung in integrierter Schaltungstechnik sehr viel Platz in Anspruch nehmen, so daß diese Lösung kaum zur Ausführung in integrierter Schaltungstechnik geeignet ist. Es kommt hinzu, daß die Eingangspegel der I²L-Schaltung dabei von der Versorgungsspannung der vorausgehenden Schaltung mitbestimmt werden, was ebenfalls von Nachteil ist.

Eine Schaltung zur Pegelanpassung für I²L-Schaltungen ist aus der DE-OS 31 37 010 bekannt. Mit der gezeigten Schaltung ist eine Umsetzung von einem Pegel auf einen anderen Pegel möglich. Damit verschiedene Pegel auf I²-Pegel angepaßt werden könnten, sind ebenso viele Schaltungen nötig. Dies wirkt sich als eine komplizierte aufwendige Lösung aus.

Aufgabe der vorliegenden Erfindung ist es, eine in integrierter Schaltungstechnik einfach herzustellende Schaltung zu schaffen, mit der verschiedene höhere Ausgangspegel einer vorangehenden Schaltung an die niedrigeren Eingangspegel einer I²L-Schaltung angepaßt werden können. Diese Aufgabe wird erfindungsgemäß durch die im Anspruch angegebenen Maßnahmen gelöst.

Der von der Stromquelle gelieferte Strom fließt dabei je nach der Stellung der Umschalter-Transistorpaare in einen der Stromspiegel und aus diesem heraus in einen Eingang der I²L-Schaltungen. Eine zusätzliche Stromquelle usw. ist also nicht erforderlich.

Die Erfindung wird nachstehend anhand der Zeichnungen näher erläutert. Es zeigen

Fig. 1 ein Schema des technologischen Aufbaues eines I²L-Gatters,

Fig. 2 das zugehörige Ersatzschaltbild,

Fig. 3 eine Schaltung nach dem Stand der Technik und

Fig. 4 eine Schaltung zum Umsetzen unterschiedlich hoher Ausgangspegel nach der Erfindung.

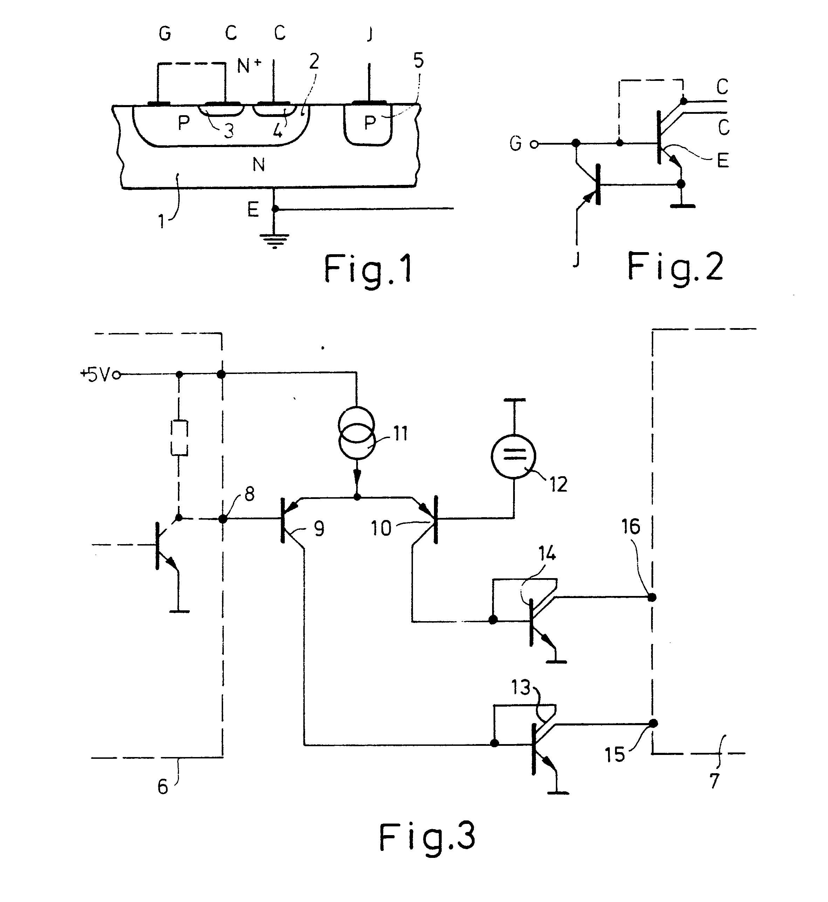

Fig. 1 zeigt einen Querschnitt durch den Halbleiterkörper eines I²L-Inverters, der ein Grundelement einer I²L-Schaltung bildet. In einer epitaktischen N-Schicht 1 ist ein P-Gebiet 2 vorgesehen, das zwei N⁺-Zonen 3 und 4 umschließt. Die Zonen 1...4 bilden einen vertikalen npn-Transistor, wobei die Zone 1 als Emitter, die Zone 2 als Basis G und die Zonen 3 und 4 als Kollektoren betrieben werden. Der hierdurch gebildete Transistor wird hier und im folgenden als Gatter-Transistor bezeichnet. In der Nähe des P-Gebietes 2 befindet sich noch ein zusätzliches P-Gebiet 5, der sogenannte Injektor, der zusammen mit der epitaktischen N-Schicht 1 und dem P-Gebiet 2 einen lateralen Transistor bildet, so daß sich das in Fig. 2 dargestellte Ersatzschaltbild ergibt.

In Fig. 3 ist mit 6 eine Verknüpfungsschaltung bezeichnet, die an ihrem Ausgang einen Pegel von 0 bzw. von 5 V führt. Dieser Pegel wird durch die Anpassungsschaltung so umgesetzt, daß die nachgeschaltete I²L-Schaltung 7 ihn verarbeiten kann. Die Anpassungsschaltung enthält einen Umschalter, der aus zwei emittergekoppelten pnp-Transistoren 9 und 10 besteht, deren miteinander verbundene Emitter über eine Stromquelle 11, die einen Gleichstrom von 20 μA liefert, an eine positive Versorgungsspanung angeschlossen ist, vorzugsweise die gleiche, mit der auch die Schaltung 6 betrieben wird. Die Basis des Transistors 9 ist mit dem Ausgang 8 der Schaltung 6 verbunden, während die Basis des Transistors 10 an eine Referenz-Spannungsquelle 12 angeschlossen ist so daß das Potential an der Basis des Transistors 10 stets größer ist als der eine Logikpegel am Ausgang 8 (0 V), aber stets kleiner als der andere Logikpegel ( + 5 V) an diesem Ausgang. Der von der Stromquelle 11 gelieferte Strom fließt daher immer über einen der beiden Transistoren 9 und 10.

Die Kollektoren der Transistoren 9 und 10 sind mit je einem Stromspiegel 13 bzw. 14 verbunden. Jeder dieser Stromspiegel wird durch einen Gatter-Transistor mit zwei Kollektoren gebildet, von denen der eine (wie in Fig. 1 und Fig. 2 gestrichelt angedeutet) mit seiner Basis verbunden ist, während der andere Kollektor — der Ausgang des Stromspiegels — mit jeweils einem Eingang 15

bzw. 16 der I²L-Schaltung verbunden ist. Die Emitter der den Stromspiegel 13 bzw. 14 bildenden Gatter-Transistoren sind mit Masse verbunden verbunden. Der von der Stromquelle 11 gelieferte Strom fließt entweder über den Transistor 9 oder den Transistor 10 des Umschalters in den damit verbundenen Stromspiegel 13 bzw. 14 und aus diesem heraus an den daran angeschlossenen Eingang 15 bzw. 16 der I²L-Schaltung 7. Die Größe des von der Stromquelle 11 gelieferten Stromes wird dabei so gewählt, daß der betreffende Eingang geschaltet werden kann.

Die Logikpegel an den Ausgängen der Stromspiegel 13 und 14 sind zueinander komplementär; Wenn der eine Stromspiegel Strom führt, führt der andere keinen und umgekehrt. Falls in der I²L-Schaltung 7 nur einer dieser beiden Pegel benötigt wird, kann einer der beiden Stromspiegel entfallen; der Kollektor des zugehörigen Transistors ist dann mit Masse verbunden. Es ist möglich, als Stromspiegel einen Transistor mit mehr als zwei Kollektorzonen zu verwenden, um damit mehr als einen Eingang der I²L-Schaltung anzusteuern. In diesem Fall müßten entweder die Flächenverhältnisse des den Stromspiegel bildenden Gatter-Transistors so gewählt werden, daß die Kollektorströme den erforderlichen Wert haben, oder der Strom der Stromquelle 11 muß entsprechend größer gewählt werden.

Die Gatter-Transistoren, die die Stromspiegel 13 und 14 bilden, werden zweckmäßigerweise im gleichen Arbeitsgang hergestellt wie die Gatter-Transistoren innerhalb der I²L-Schaltung 7, was die Herstellung vereinfacht. Die Stromquelle 11 kann durch einen pnp-Transistor gebildet werden, der Teil eines Stromspiegels ist. Die Referenzspannung an der Basiselektrode des Transistors 10 kann aus der Versorgungsspannung mittels eines Dioden enthaltenden Spannungsteilers abgeleitet werden.

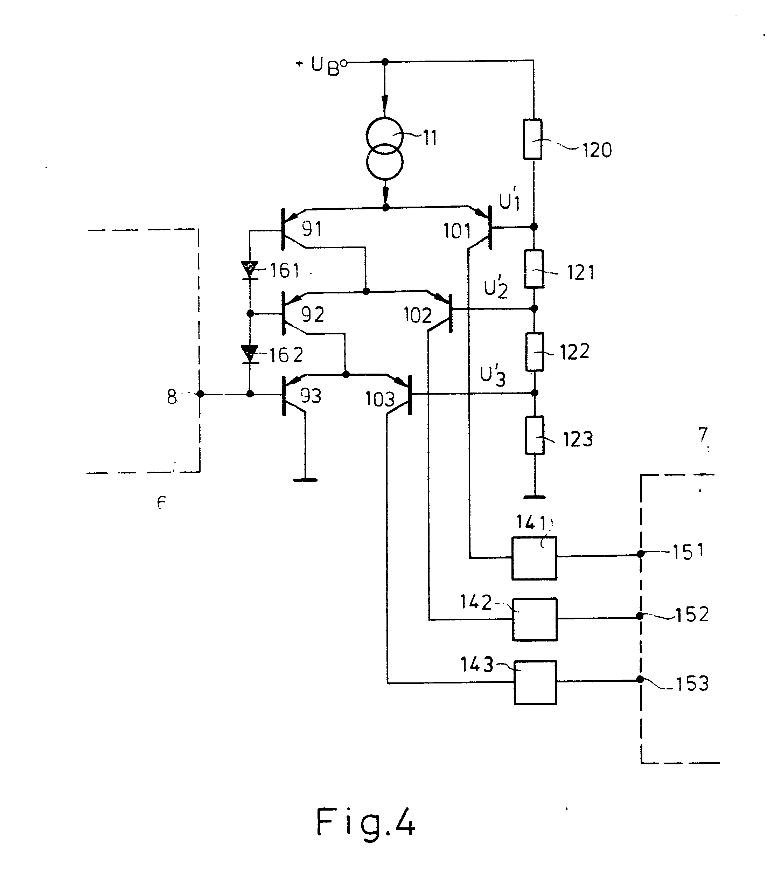

Die in Fig. 3 dargestellte Schaltung ist in der Lage, zwei verschiedene Eingangspegel (0 V/5 V) für eine nachfolgende I²L-Schaltung aufzubereiten. Wenn stattdessen n-Eingangspegel aufbereitet werden müßten (n > 2), dann wäre dies grundsätzlich mit n-1-Anpassungsschaltungen gemäß Fig. 3 möglich. Hierfür wären jedoch n-1-Eingangsklemmen und ebenso viele Stromquellen erforderlich. Eine wesentlich einfachere Ausgestaltung nach der Erfindung ist in Fig. 4 dargestellt (für n = 4). Die Schaltung besteht aus drei emittergekoppelten Transistorpaaren 91-101, 92-102, 93-103. Die Basiselektroden der Transistoren 91, 92 und 93 sind miteinander sowie mit dem Ausgang 8 der Schaltung 6 verbunden, an dem vier verschiedene Potentiale — V, $U_1$, $U_2$, $U_3$ auftreten können. Die Potentiale $U_1...U_3$ sind dabei positiv, wobei $U_2$ größer als $U_3$ und $U_1$ größer als $U_2$ und maximal gleich der Versorgungsspannung $U\beta$. Die miteinander verbundenen Emitter des pnp-Transistorpaares 91, 101 sind über die Stromquelle 11 an die positive Versorgungsspannung angeschlossen, während die Emitter des pnp-Transistorpaares 92-102 mit dem Kollektor des Transistors 91 und die Emitter des pnp-Transistorpaares 93-103 mit dem Kollektor des Transistors 92 verbunden sind. Die Basen der Transistoren 101, 102 und 103 sind mit den drei Abgriffen eines aus vier Widerständen 120...123 bestehenden Mehrfach-Spannungsteilers verbunden, so daß sich an der Basis des Transistors 101 die Gleichspannung $U'_1$, an der Basis des Transistors 102 die Gleichspannung $U'_2$ und an der Basis des Transistors 103 die Gleichspannung $U_3$ ergibt. Der Mehrfach-Spannungsteiler 120...123 ist dabei so bemessen, daß — bezogen auf das Massepotential — die Spannung $U'_3$ niedriger ist als die Spannung $U_3$, die Spannung $U'_2$ niedriger ist als die Spannung $U_2$ aber höher als die Spannung $U_3$ und die Spannung $U'_1$ niedriger ist als die Spannung $U_1$ aber höher als die Spannung $U_2$. Die Kollektoren der Transistoren 101, 102 und 103 sind über je einen Stromspiegel 141, 142, 143 mit je einem Eingang (151, 152 bzw. 153) der I²L-Schaltung verbunden.

Wenn der Pegel am Ausgang 8 $U_1$ entspricht, führt bei dieser Schaltung nur der Stromspiegel 141 einen Strom, während bei dem Pegel $U_2$ am Eingang 8 nur der Stromspiegel 142 und bei dem Pegel 103 nur der Stromspiegel 143 einen Strom führt. Bei 0 V am Eingang 8 führt keiner der Stromspiegel einen Strom; gegebenenfalls kann aber auch in diesem Fall mit Hilfe eines Stromspiegels in der Kollektorzuleitung des Transistors 93 ein Signal an die I²L-Schaltung 7 geliefert werden.

Um zu vermeiden, daß parasitäre Transistoren wirksam werden, können Dioden 161, 162 vorgesehen sein, die sich ohne wesentlichen Platzbedarf in die Transistoren 92, 93 integrieren lassen.

**Patentanspruch**

Schaltungsanordnung zur Pegelanpassung zwischen I²L-Schaltung und einer vorgeschalteten Verknüpfungsschaltung mit einer Gleichstromquelle (11), die mit dem Eingang eines in Abhängigkeit vom Pegel am Ausgang (8) der Verknüpfungsschaltung (6) steuerbaren Umschalters (9, 10) verbunden ist, wobei wenigstens einer der beiden Ausgänge des Umschalters mit dem Eingang eines Stromspiegels (13, 14) verbunden ist, dessen Ausgang mit dem Eingang (15, 16) der I²L-Schaltung verbunden ist, dadurch gekennzeichnet, daß die Schaltungsanordnung zum Umsetzen von n verschiedenen Pegeln am Ausgang der vorangehenden Schaltung ausgelegt ist, wobei n-1 emittergekoppelte Transistorpaare (91, 101; 92, 102; 93, 103) vorgesehen sind, daß die Basis je eines Transistors (91, 92, 93) eines jeden Paares mit dem Ausgang (8) der vorangehenden Schaltung gekoppelt ist, daß die Kollektor-Emitter-Strecken dieser Transistoren in Reihe geschaltet sind, wobei der nicht mit einem Kollektor verbundene Emitter des einen Transistorpaares (91, 101) mit der Stromquelle (11) verbunden ist, und daß die Kollektorelektroden der jeweils anderen Transistoren (101, 102, 103) der Transistorpaare mit je einem Stromspiegel (141, 142, 143) und deren Basiselektroden mit je einer Referenzspannung ($U'_1$, $U'_2$, $U'_3$) verbunden sind, wobei die Referenzspannungen an den Basiselektroden so gestaffelt sind, daß — bezogen auf die Versorgungsspannungsklemme, mit der die Stromquelle verbunden ist — das mit der Stromquelle (11) verbundene Transistorpaar die niedrigste Spannung ($U'_1$), das damit verbundene Transistorpaar die zweitniedrigste Spannung ($U'_2$) erhält usw.

## Claim

A circuit arrangement for level adaptation between an I²L circuit and a preceding combinatory logic circuit, comprising a direct current source (11) which is connected to the input of a switch (9, 10) which can be controlled in dependence on the level at the output (8) of the combinatory logic circuit (6), at least one of the two outputs of the switch being connected to the input of a current mirror (13, 14) whose output is connected to the input (15, 16) of the I²L circuit, characterized in that the circuit arrangement is designed for the conversion of n different levels at the output of the preceding circuit, there being provided n-1 emitter-coupled transistor pairs (91, 101 ; 92, 102 ; 93, 103), the base of each time one transistor (91, 92, 93) of each pair being coupled to the output (8) of the preceding circuit, the collector-emitter paths of these transistors being connected in series, the emitter of one transistor pair (91, 101) which is not connected to a collector being connected to the current source (11), the collector electrodes of each time the other transistor (101, 102, 103) of the transistor pairs being connected to a respective current mirror (141, 142, 143), the base electrodes thereof being connected to a respective reference voltage ($U'_1$, $U'_2$, $U'_3$), the reference voltages at the base electrodes being staggered so that, relative to the supply voltage at a terminal whereto the current source is connected, the transistor pair which is connected to the current source (11) receives the lowest voltage ($U'_1$), the transistor pair which is connected thereto receiving the lowest voltage but one ($U'_2$), etc.

## Revendication

Montage de circuit pour l'adaptation de niveau entre un circuit I²L et un circuit combinatoire placé en amont, comportant une source de courant continu (11), qui est connectée à l'entrée d'un commutateur (9, 10) pouvant être commandé en fonction du niveau présent sur la sortie (8) du circuit combinatoire (6), au moins une des deux sorties du commutateur étant connectée à l'entrée d'un miroir de courant (13, 14) dont la sortie est connectée à l'entrée (15, 16) du circuit I²L, caractérisé en ce que le montage du circuit est conçu pour convertir n niveaux différents sur la sortie du circuit placé en amont, n-1 paires de transistors couplés par les émetteurs (91, 101 ; 92, 102 ; 93, 103) étant prévues, que la base d'un transistor (91, 92, 93) de chaque paire est chaque fois couplée à la sortie (8) du circuit placé en amont, que les trajets collecteur-émetteur de ces transistors sont connectés en série, l'émetteur non connecté à un collecteur de la première paire de transistors (91, 101) étant connecté à la source de courant (11), et que les électrodes de collecteur des autres transistors (101, 102, 103) des paires de transistors sont connectées chacune à un miroir de courant (141, 142, 143) et leurs électrodes de base, chacune à une tension de référence ($U'_1$, $U'_2$, $U'_3$), les tensions de référence sur les électrodes de base étant échelonnées d'une manière telle que, avec référence à la borne de tension d'alimentation à laquelle la source de courant est connectée, la paire de transistors connectée à la source de tension (11) porte la tension la plus basse ($U'_1$), la paire de transistors qui y est connectée, la tension la plus basse à une près ($U'_2$), etc.

Fig.1

Fig.2

Fig.3

Fig.4